# EUROPEAN PATENT APPLICATION

(11) **EP 4 270 469 A1**
(43) Date of publication of application: **01.11.2023**
(21) Application number: 22170731.8
(22) Date of filing: 29.04.2022
(51) Int. Cl.: H01L 23/24, H01L 23/04

(54) **POWER SEMICONDUCTOR MODULE**

(71) Applicant: Infineon Technologies AG, 85579 Neubiberg (DE)
(72) Inventor: LUDWIG, Marco, 58739 Wickede (DE); GOLDAMMER, Martin, 59494 Soest (DE)
(74) Representative: Westphal, Mussgnug & Partner, Patentanwälte mbB

(57) **Abstract**

A power semiconductor module arrangement comprises a substrate comprising a dielectric insulation layer and a first metallization layer attached to the dielectric insulation layer, at least one semiconductor body arranged on the first metallization layer, a housing at least partly enclosing the substrate, the housing comprising a plurality of sidewalls and a lid, a casting compound formed of a first material and partly filling the housing, thereby covering the substrate and the at least one semiconductor body arranged thereon, a first element extending from the lid of the housing into the casting compound in a direction towards the substrate, and a detaining element arranged between the first element and at least one of the plurality of sidewalls of the housing, and configured to prevent traces of the first material wetting the lid of the housing from flowing along the lid from the first element to the one or more sidewalls.

## Description

### TECHNICAL FIELD

The instant disclosure relates to a power semiconductor module, in particular to a power semiconductor module comprising a casting compound.

### BACKGROUND

Power semiconductor modules often include a substrate arranged in a housing. A semiconductor arrangement including a plurality of controllable semiconductor elements (e.g., two IGBTs in a half-bridge configuration) may be arranged on the substrate. The substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer.

The housing may be partly filled with a casting compound to protect the components and electrical connections inside the power semiconductor module, in particular inside the housing, from certain environmental conditions, mechanical damage and insulation faults. When the casting compound is formed, usually a liquid, semi-liquid or viscous material is poured into the housing, thereby forming a liquid or viscous pre-layer. A heating step may follow during which liquid that is present in the pre-layer is at least partly evaporated. In this way, the pre-layer is hardened to form the resulting casting compound. There is a risk that a lid of the housing is wetted by the material of the casting compound during the heating step. The material may unintentionally leak out of the housing.

There is a need for a semiconductor module arrangement that prevents the material of the casting compound from leaking out of the housing.

### SUMMARY

A power semiconductor module arrangement includes a substrate including a dielectric insulation layer and a first metallization layer attached to the dielectric insulation layer, at least one semiconductor body arranged on the first metallization layer, a housing at least partly enclosing the substrate, the housing including a plurality of sidewalls and a lid, a casting compound formed of a first material and partly filling the housing, thereby covering the substrate and the at least one semiconductor body arranged thereon, a first element extending from the lid of the housing into the casting compound in a direction towards the substrate, and a detaining element arranged between the first element and at least one of the plurality of sidewalls of the housing, and configured to prevent traces of the first material wetting the lid of the housing from flowing along the lid from the first element to the one or more sidewalls.

The invention may be better understood with reference to the following drawings and the description. The components in the figures are not necessarily to scale, emphasis instead being placed upon illustrating the principles of the invention. Moreover, in the figures, like reference numerals designate corresponding parts throughout the different views.

### BRIEF DESCRIPTION OF THE DRAWINGS

Figure 1 is a cross-sectional view of a power semiconductor module without a casting compound.
Figure 2 is a cross-sectional view of a power semiconductor module with a casting compound.
Figure 3 is a cross-sectional view of an example of a power semiconductor module with material of the casting compound leaking out of the housing during a heating step.
Figure 4 is a cross-sectional view of a power semiconductor module comprising a detaining structure according to one example.
Figure 5 is a cross-sectional view of a power semiconductor module comprising a detaining structure according to another example.
Figure 6 is a cross-sectional view of a power semiconductor module comprising a detaining structure according to an even further example.
Figure 7, including Figures 7A to 7G, illustrates bottom views of a lid of a housing comprising a detaining structure according to different examples.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to designate different "elements". That is, e.g., the existence of a "third element" does not require the existence of a "first element" and a "second element". An electrical line or electrical connection as described herein may be a single electrically conductive element, or may include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or may be included in a semiconductor chip. A semiconductor body has electrically connecting pads and includes at least one semiconductor element with electrodes.

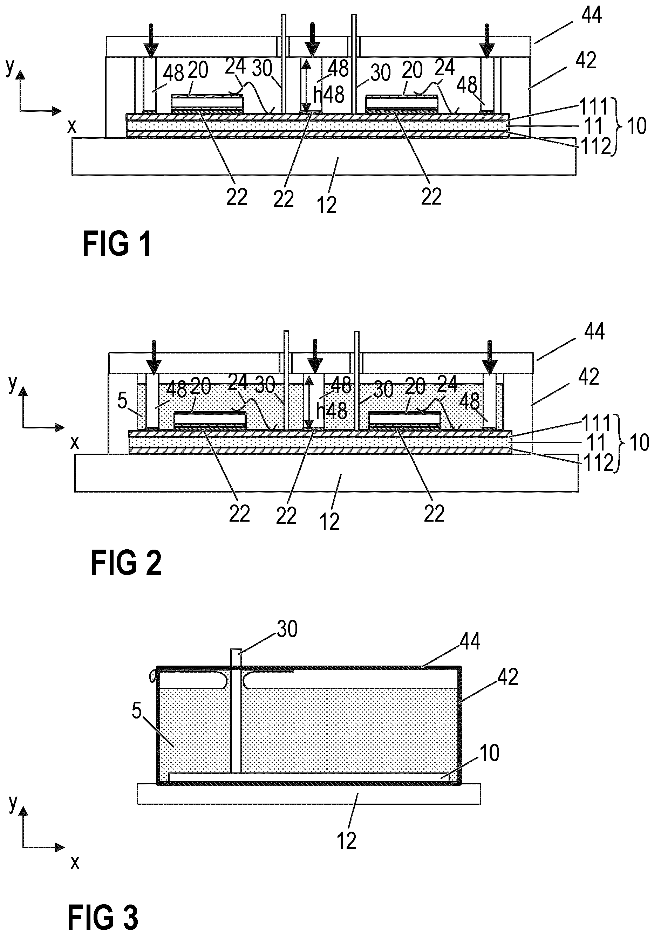

Referring to Figure 1, a cross-sectional view of an exemplary power semiconductor module is illustrated. The power semiconductor module includes a housing and a substrate 10. The substrate 10 includes a dielectric insulation layer 11, a (structured) first metallization layer 111 attached to the dielectric insulation layer 11, and a second (structured) metallization layer 112 attached to the dielectric insulation layer 11. The dielectric insulation layer 11 is disposed between the first and second metallization layers 111, 112. It is, however, also possible that the substrate 10 only comprises a first metallization layer 111, and that the second metallization layer 112 is omitted.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AlN, SiC, BeO or Si₃N₄. For instance, the substrate 10 may be, e.g., a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing. In the example illustrated in Figure 1, the substrate 10 is arranged on a ground surface 12 of the housing. The housing further comprises sidewalls 42 and a lid 44. In other examples, however, the ground surface 12 of the housing may be omitted. In such cases the substrate 10 itself may form the ground surface of the housing (often also referred to as base plate-less modules). The substrate 10 may also be arranged on a base plate or heat sink 12, for example. In the example in Figure 1, only one substrate 10 is arranged on the ground surface, base plate or heat sink 12 (only referred to as ground surface in the following). In some power semiconductor module arrangements, more than one substrate 10 may be arranged in a single housing. The ground surface 12, the sidewalls 42 and the lid 44 may include a metal or a metal alloy, for example. It is, however, also possible that the ground surface 12, sidewalls 42 and lid 44 comprise an electrically insulating material such as a plastic or ceramic material, for example. The housing may also include a liquid crystal polymer, for example. Other materials are also possible. In the examples illustrated herein, the housing is rectangular or has a square shape and has four sidewalls 42. This, however, is only an example. It is generally possible that the housing comprises any number of sidewalls (e.g., three, four, or even more). The number of sidewalls is not relevant for the present invention.

In a power semiconductor module comprising a ground surface 12, the substrate 10 may be connected to the ground surface 12 by means of a connection layer (not specifically illustrated in Figure 1). Such a connection layer may be a solder layer, a layer of an adhesive material, or a layer of a sintered metal powder, e.g., a sintered silver powder, for example. Any other kind of electrically conducting or non-conducting connection layer is also possible. As has been mentioned before, the ground surface 12 and a corresponding connection layer may also be omitted entirely.

One or more semiconductor bodies 20 may be arranged on the substrate 10. Each of the semiconductor bodies 20 arranged on the substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. The first metallization layer 111 of the example in Figure 1 is also a continuous layer. However, the first metallization layer 111, or the second metallization layer 112, or both can also be structured layers. "Structured layer" means that, e.g., the respective metallization layer 111, 112 is not a continuous layer, but includes recesses between different sections of the layer. Different semiconductor bodies 20 may be mounted to the same or to different sections of the first metallization layer 111. Different sections of the first metallization layer 111 may have no electrical connection or may be electrically connected to one or more other sections using, e.g., bonding wires. Electrical connections may also include bonding ribbons, connection plates or conductor rails, for example, to name just a few examples. According to another example, the second metallization layer 112 can be omitted altogether. The one or more semiconductor bodies 20 may be electrically and mechanically connected to the substrate 10 by an electrically conductive connection layer 22. Such an electrically conductive connection layer 22 may be a solder layer, a layer of an electrically conductive adhesive, or a layer of a sintered metal powder, e.g., a sintered silver powder, for example.

The power semiconductor module further includes terminal elements 30. The terminal elements 30 are electrically connected to the substrate 10, e.g., to the first metallization layer 111 of the substrate 10, and form a contact element which provides an electrical connection between the inside and the outside of the housing. A first end of the terminal elements 30 may be electrically and mechanically connected to the first metallization layer 111 by an electrically conductive connection layer (not specifically illustrated). Such an electrically conductive connection layer may be a solder layer, a layer of an electrically conductive adhesive, or a layer of a sintered metal powder, e.g., a sintered silver powder, for example. A second end of the terminal elements 30 protrudes out of the housing to allow the terminal element 30 to be electrically contacted from the outside. The lid 44 may comprise through holes or openings through which the terminal elements 30 may protrude such that their first end is inside the housing and their second end is outside the housing. The terminal elements 30 may protrude vertically (i.e., perpendicular to a top surface of the substrate 10) out of the housing when the housing is arranged to surround the substrate 10. According to another example, terminal elements 30 may also protrude horizontally (parallel to the top surface of the substrate 10) through a sidewall 42 of the housing.

The semiconductor module arrangement illustrated in Figure 1 further comprises press-on pins 48. The press-on pins 48 are arranged on the substrate 10, for example. In Figure 1, the press-on pins 48 are illustrated as being arranged at a certain distance from the different semiconductor bodies 20 in a horizontal direction x. This, however, is only an example. Generally, press-on pins 48 may also be arranged in close vicinity to at least one of the semiconductor bodies 20. According to another example, press-on pins 48 may even be arranged on a semiconductor body 20 instead of on the substrate 10. If the press-on pin 48 is arranged on a semiconductor body 20, the respective semiconductor body 20 is arranged between the press-on pin 48 and the substrate 10. The press-on pin 48 may be arranged at a central position within the housing. That is, the press-on pin 48 may be arranged at a first distance from a first sidewall and at a second distance from a second sidewall opposite the first sidewall, wherein the first distance equals the second distance, and at a third distance from a third sidewall and at a fourth distance from a fourth sidewall opposite the third sidewall, wherein the third distance equals the fourth distance. Press-on pins, however, may also be arranged at any other suitable position within the housing.

When the semiconductor module arrangement is fully assembled, the substrate 10 is pressed onto the ground surface 12 by means of the press-on pins 48 in order to reduce a thermal resistance between the substrate 10 and the ground surface 12. Further, the substrate 10 is thereby kept in a desired position and is prevented from shifting inside the housing. When the lid 44 is arranged on the sidewalls 42 to close the housing, the lid 44 contacts the press-on pins 48 and exerts a pressure on the press-on pins 48. The bold arrows in Figure 1 illustrate a direction in which the lid 44 is moved while closing the housing and a direction of the pressure exerted on the press-on pin 48 once the housing is fully closed.

Many power semiconductor modules further include a casting compound 5, as is illustrated in the example of Figure 2. The casting compound 5 may consist of or include a silicone gel or may be a rigid molding compound, for example. The casting compound 5 may partly fill the interior of the housing, thereby covering the substrate 10 and the semiconductor bodies 20, and any other components and electrical connections 24 that are arranged on the substrate 10. Electrical connections 24 such as, e.g., bonding wires or bonding ribbons, may electrically couple the semiconductor bodies 20 to the first metallization layer 111, to other semiconductor bodies 20, or to any other components that may be arranged inside the housing. The terminal elements 30 may be partly embedded in the casting compound 5. At least the second ends of the terminal elements 30, however, may not be covered by the casting compound 5 and may protrude from the casting compound 5. The same applies for the press-on pins 48. The casting compound 5 is configured to protect the components and electrical connections inside the power semiconductor module arrangement, in particular inside the housing, from certain environmental conditions, mechanical damage and insulation faults.

When the casting compound 5 is formed, usually a liquid, semi-liquid or viscous material is poured into the housing, thereby forming a liquid or viscous pre-layer. In many cases, the lid 44 is already arranged on the sidewalls 42 at this point. The lid 44, for example, may comprise an opening through which the liquid, semi-liquid or viscous material may be poured into the housing. A heating step may follow during which liquid that is present in the pre-layer is at least partly evaporated. In this way, the pre-layer is hardened to form the resulting casting compound 5. The liquid, semi-liquid or viscous material is generally poured into the housing at room temperature. During the following heating step, the liquid, semi-liquid or viscous material is heated to temperatures of up to 120°C or even more. When heat is applied to the liquid, semi-liquid or viscous material of the casting compound 5, liquid that is present in the pre-layer evaporates and a cross-linking process is started. After a certain time, e.g., 10 to 20 minutes, the material is sufficiently cured, thereby forming the resulting casting compound 5.

During the heating step, the liquid, semi-liquid or viscous material expands to a certain degree, due to the high temperatures. As has been described above, certain elements such as, e.g., the terminal elements 30 or the press-on elements 48, extend from the lid 44 of the housing toward the substrate 10. A part of such elements, therefore, is embedded in the liquid, semi-liquid or viscous material of the pre-layer, while another part of the elements extends out of the liquid, semi-liquid or viscous material and towards the lid 44. This may be the case for other elements of the power semiconductor module as well. There is a risk that when the material expands during the heating step, and further under the influence of, e.g., a capillary or any other effects, the material creeps along such elements in a vertical direction y to the inner surface of the lid 44, the inner surface of the lid 44 being a surface facing towards the substrate 10. In this way, the inner surface of the lid 44 may be wetted by the material of the pre-layer. If a certain amount of material collects on the inner surface of the lid 44, it may further creep along the lid 44 towards the sidewalls 42. There it may unintentionally leak out of the housing, especially at the beginning of the heating step when the material is not yet sufficiently cross-linked and hardened. The leaking of material out of the housing is schematically illustrated in the arrangement illustrated in Figure 3. The material wetting the lid 44 and leaking out of the housing may negatively affect the performance and the lifetime of the power semiconductor module.

In order to prevent the material that is supposed to form the casting compound 5 from wetting the inside of the lid 44 and from leaking out of the housing, a detaining element 60 is arranged between the first element 80 and at least one of the plurality of sidewalls 42 of the housing. The detaining element 60 is configured to prevent traces of the first material wetting the lid 44 from flowing along the lid 44 from the first element 80 to the one or more sidewalls 42. As has been described above, the first element may be any element which extends from the lid 44 towards the substrate 10 and into the material of the casting compound 5 such as, e.g., a terminal element 30, a press-on element 48, or any other kind of element. The first element 80 does not necessarily extend all the way to the substrate 10, but at least from the lid 44 into the material of the casting compound 5.

The detaining element 60 may be arranged between the first element 80 and only one of the plurality of sidewalls 42, or between the first element 80 and two or more of the plurality of sidewalls 42. This may depend on different factors. For example, the first element 80 may not be arranged centrally within the housing, but closer to some of the sidewalls 42 than to others. Therefore, the risk of leaking out of the housing may only exist for some of the sidewalls 42, but not for others. For example, a distance between the first element 80 and a first sidewall 42 may be large enough such that there is a very low or even no risk at all that material creeping along the first element 80 may further creep along the lid 44 all the way to the first sidewall 42 before sufficient cross-linking occurs. Generally, a power semiconductor module may comprise more than one first element 80 and more than one detaining element 60. However, the general principle is described by means of only one first element 80 herein.

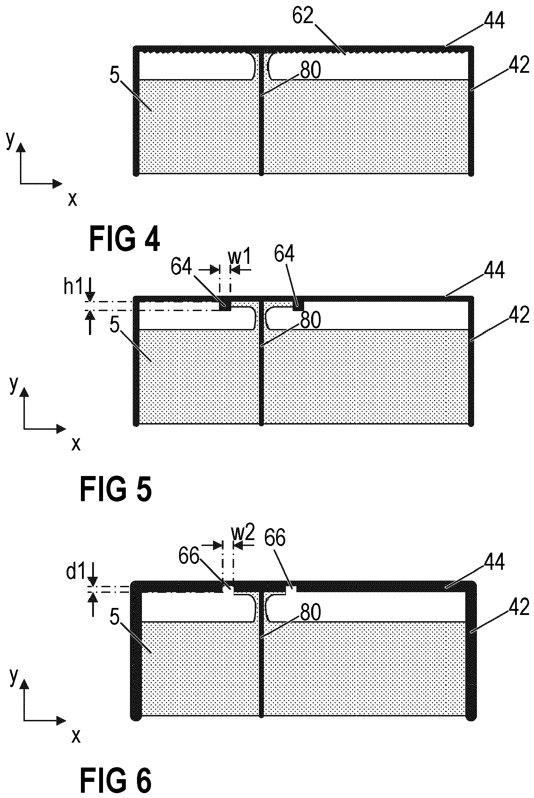

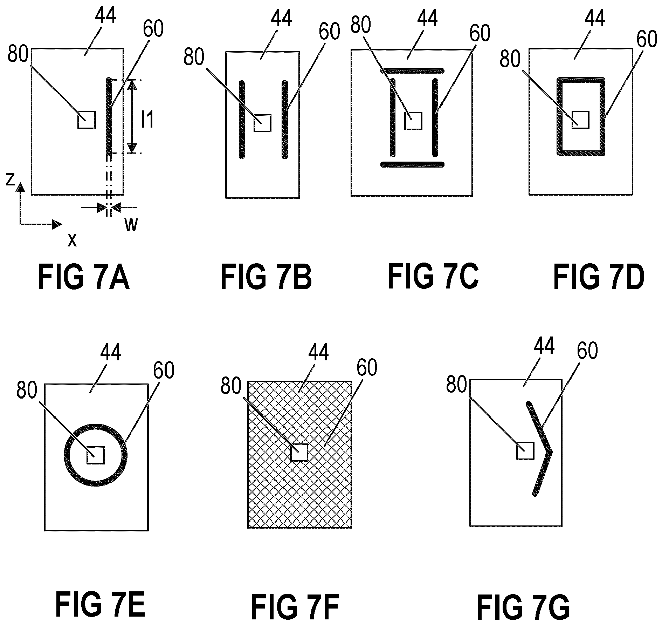

The detaining element 60 may be implemented in different ways. Different examples of detaining elements 60 will be described in the following. According to one example, which is schematically illustrated in Figure 4, the detaining element 60 may comprise a roughened section 62 of an inner surface of the lid 44. The inner surface of the lid 44 generally is comparably smooth. At least a section of the inner surface, however, may be roughened. While the material of the casting compound 5 may creep rather unhindered along a smooth surface, it may be stopped entirely or may at least be delayed by a roughened surface. A roughness depth Rz of the concerned section may be, e.g., at least 0.5mm, or at least 1mm. According to one example, the roughness depth Rz is less than RZ 100. In the example illustrated in Figure 4, the entire inner surface of the lid 44 is roughened. This, however, is only an example. It is generally also possible to just form defined roughened sections 62. Such roughened sections 62 may have, e.g., an elongated form (e.g., rectangular), as will be described with respect to Figure 7 further below. A size of the one or more roughened sections 62 may depend on a size of the first element 80 or a distance between the first element 80 and the respective sidewall 42, for example. According to one example, a roughened section may have a width w of at least 2mm, or at least 5mm in a first horizontal direction x, and a length 11 in a second horizontal direction z of at least 5mm, or at least 10mm (see, e.g., Figure 7). According to one example, different micro structures are formed (e.g., grids or lines) which may form the desired roughened section 62.

A roughened section 62 may be formed, e.g., by means of a plasma process, by means of a sandblast process, or through laser structuring technology. A roughened section, however, may also be formed by means of any other suitable process. The lid 44 may be an injection-molded part. It is, therefore, also possible to form the roughened section 62 by providing a roughened surface in the injection mold such that the roughened section 62 is formed during the injection molding process.

Now referring to Figure 5, according to another example, the detaining element 60 may comprise at least one elongated elevation 64. The at least one elongated elevation 64 may extend from the inner surface of the lid 44 towards the substrate 10. After forming the liquid, semi-liquid or viscous pre-layer at room temperature and before performing the heating step, however, the at least one elongated elevation 64 does not directly contact the liquid, semi-liquid or viscous pre-layer in order to not give rise to the same effects as the first element 80. According to one example, the at least one elongated elevation 64 has a height h1 in the vertical direction y of between 1mm and 5mm, or between 1mm and 3mm. According to one example, an elongated elevation 64 may have a width w1 of at least 2mm, or at least 5mm in a first horizontal direction x, and a length 11 in a second horizontal direction z of at least 5mm, or at least 10mm (see, e.g., Figure 7). The exact dimensions, however, generally depend on different factors and may be chosen adequately depending on the specific dimensions and requirements of the respective power semiconductor module.

The at least one elongated elevation 64 may be easily formed by means of a glue bead, for example. According to another example, the elongated elevation 64 may be an injection molded element and may be formed together with the lid 44. The elongated elevation 64 may also be formed by a separate element that is attached to the lid 44 (e.g., glued, screwed or soldered). In the example illustrated in Figure 5, the elongated elevations 64 have an angular shape. This, however, is only an example. The elongated elevations may also have other shapes such as rounded, for example. Different possible arrangements of elongated elevations 64 will be described in further detail with respect to Figure 7 below.

Now referring to Figure 6, according to another example, the detaining element 60 may comprise at least one elongated trench 66 extending from the inner surface of the lid 44 towards an outer surface of the lid 44. That is, a thickness of the lid 66 is locally reduced to form the elongated trench 66. According to one example, the at least one elongated trench 66 has a depth d1 in the vertical direction y of between 0.5mm and 2mm, or between 1mm and 1.5mm. According to one example, an elongated trench 66 may have a width w2 of at least 2mm, or at least 5mm in a first horizontal direction x, and a length 11 in a second horizontal direction z of at least 5mm, or at least 10mm (see, e.g., Figure 7). The exact dimensions, however, generally depend on different factors and may be chosen adequately depending on the specific dimensions and requirements of the respective power semiconductor module. In the example illustrated in Figure 6, the elongated trenches 66 have an angular shape. This, however, is only an example. The elongated trenches 66 may also have other suitable shapes. The desired effect may be more pronounced if the elongated trenches 66 have sharp edges formed at acute or right angles, for example.

The at least one elongated trench 66 may be formed in the lid 44 by means of a laser process, or a milling process, for example. It is also possible, if the lid 44 is an injection-molded part, that the elongated trenches 66 are already formed during the injection-molding process when the lid 44 is formed.

All of the exemplary detaining elements 60 described above have the same function, namely stopping or at least delaying material of the casting compound 5 that creeps along the first element 80 towards the lid 44 and further along the inner surface of the lid 44 towards one or more sidewalls 42 of the housing.

Now referring to Figure 7, different possible arrangements of detaining elements 60 are exemplarily illustrated. Figure 7 illustrates several exemplary bottom views of a lid 44 of a housing. That is, the inner surface of the lid 44 as well as the position of a first element 80 and a detaining element 60 are exemplarily illustrated. Everything that is discussed in the following equally applies for all kinds of detaining elements 60 (e.g., roughened section 62, elevation 64, trench 66). Now referring to Figure 7A, according to a first example, the first element 80 is arranged comparably close to one of the sidewalls 42, while it is arranged comparably far away to all other sidewalls 42 of the housing. In this case, it may be sufficient to arrange a detaining element 60 only between the first element 80 and the respective sidewall 42 it is arranged closest to. As has been discussed above, the detaining element 60 may have an elongated form. That is, a width w in the first horizontal direction x may be significantly smaller than a length 11 in the second horizontal direction z (e.g., at least 10 times smaller). In this way, the detaining element 60 may extend in parallel to the respective sidewall. It is, however, also possible that an elongated detaining element 60 is not (entirely) straight. As is exemplarily illustrated in Figure 7G, the detaining element 60 may also have a V-shape, for example. Many other shapes (e.g., curved shapes) are also possible to prevent the material from reaching the sidewall 42.

In the example illustrated in Figure 7B, the first element 80 is arranged closer to each of the two longitudinal sidewalls 42 of the housing, than to the two narrow sidewalls 42 of the housing. Therefore, the detaining element 60 in this example comprises two elongated elements, each arranged between the first element 80 and the respective longitudinal sidewall 42. The two elongated elements in this example are arranged in parallel to each other (and in parallel to the respective sidewalls 42) on opposite sides of the first element 80. However, the elongated elements in this example may also have different shapes such as, e.g., a V-shape, as has been described with regard to Figure 7G above. Many other shapes (e.g., curved shapes) are also possible to prevent the material from reaching the sidewalls 42.

In the example illustrated in Figure 7C, the first element 80 is arranged at an equal distance from each of the plurality of sidewalls 42. Therefore, the detaining element 60 in this case comprises an elongated element between the first element 80 and each of the plurality of sidewalls 42. The elongated elements in this example may also have different shapes such as, e.g., a V-shape, as has been described with regard to Figure 7G above. Many other shapes (e.g., curved shapes) are also possible to prevent the material from reaching the sidewalls 42. In the examples described with respect to Figures 7A, 7B and 7C, each of the different elongated elements is separate and distinct from each of the other elongated elements.

It is, however, also possible that the detaining element 60 comprises a single elongated element which surrounds the first element 80. That is, the detaining element 60 may form a closed loop around the first element 80. In the example illustrated in Figure 7D, the detaining element 60 forms a closed loop around the first element 80 and has a rectangular shape. In the example illustrated in Figure 7E, the detaining element 60 forms a closed loop around the first element 80 and has a round shape. Many other shapes are also possible in this regard such as, e.g., an oval shape, a square shape, a triangular shape, or a polygonal shape. It is also possible that the detaining element 60 has some kind of irregular shape. For example, the course of the detaining element 60 may depend on other elements arranged on the inside of the lid 44.

In the example illustrated in Figure 7F, the entire inner surface of the lid 44 is roughened, as has been described with respect to Figure 3 above. A roughened section, however, may have any other shape, as has been described with respect to Figures 7A to 7E, and 7G.

## Claims

1. A power semiconductor module arrangement comprising:
a substrate (10) comprising a dielectric insulation layer (11) and a first metallization layer (111) attached to the dielectric insulation layer (11);
at least one semiconductor body (20) arranged on the first metallization layer (111);
a housing at least partly enclosing the substrate (10), the housing comprising a plurality of sidewalls (42) and a lid (44);
a casting compound (5) formed of a first material and partly filling the housing, thereby covering the substrate (10) and the at least one semiconductor body (20) arranged thereon;
a first element (80) extending from the lid (44) of the housing into the casting compound (5) in a direction towards the substrate (10); and
a detaining element (60) arranged between the first element (80) and at least one of the plurality of sidewalls (42) of the housing, and configured to prevent traces of the first material wetting the lid (44) of the housing from flowing along the lid (44) from the first element (80) to the one or more sidewalls (42).

2. The power semiconductor module arrangement of claim 1, wherein the detaining element (60) comprises at least one elongated elevation (64).

3. The power semiconductor module arrangement of claim 2, wherein the detaining element (60) comprises one elevation (64) surrounding the first element (80), the elevation (64) having a round shape, an oval shape, a rectangular shape, a square shape, a triangular shape, or a polygonal shape.

4. The power semiconductor module arrangement of claim 2, wherein each of the at least one elongated elevation (64) is arranged between the first element (80) and a different one of the plurality of sidewalls (42).

5. The power semiconductor module arrangement of claim 4, wherein the detaining element (60) comprises two or more elongated elevations (64), wherein each of the two or more elongated elevations (64) is separate and distinct from each of the other elongated elevations (64).

6. The power semiconductor module arrangement of claim 5, wherein at least two of the at least two elongated elevations (64) are arranged in parallel to each other on opposite sides of the first element (80).

7. The power semiconductor module arrangement of any of claims 2 to 6, wherein the at least one elongated elevation (64) comprises a glue bead.

8. The power semiconductor module arrangement of any of claims 2 to 6, wherein the at least one elongated elevation (64) is an injection molded element.

9. The power semiconductor module arrangement of claim 1, wherein the detaining element (60) comprises a roughened section (62) of an inner surface of the lid (44), the inner surface of the lid (44) facing towards the substrate (10).

10. The power semiconductor module arrangement of claim 9, wherein the roughened section (62) covers the entire inner surface of the lid (44).

11. The power semiconductor module arrangement of claim 9, wherein the roughened section (62) only partly covers the inner surface of the lid (44), and surrounds the first element (80), and has a round shape, an oval shape, a rectangular shape, a square shape, a triangular shape, or a polygonal shape.

12. The power semiconductor module arrangement of claim 1, wherein the detaining element (60) comprises at least one elongated trench (66) extending from an inner surface of the lid (44) towards an outer surface of the lid (44), the inner surface of the lid (44) facing towards the substrate (10).

13. The power semiconductor module arrangement of claim 12, wherein the detaining element (60) comprises one trench (66) that surrounds the first element (80) and has a round shape, an oval shape, a rectangular shape, a square shape, a triangular shape, or a polygonal shape.

14. The power semiconductor module arrangement of claim 12, wherein each of the at least one trench (66) is arranged between the first element (80) and a different one of the plurality of sidewalls (42).

15. The power semiconductor module arrangement of claim 14, wherein the detaining element (60) comprises two or more elongated trenches (66), wherein each of the two or more elongated trenches (66) is separate and distinct from each of the other elongated trenches (66).
